(19) Europäisches Patentamt
European Patent Office
Office européen des brevets

(11) EP 2 712 018 B1

(12) EUROPEAN PATENT SPECIFICATION

(45) Date of publication and mention
of the grant of the patent:
**10.01.2018 Bulletin 2018/02**

(51) Int Cl.:
**H01M 10/44** [(2006.01)]    **H02J 7/00** [(2006.01)]

(21) Application number: **13179455.4**

(22) Date of filing: **06.08.2013**

(54) **Protection apparatus for secondary battery**

Schutzvorrichtung für Sekundärbatterie

Appareil de protection de batterie secondaire

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.09.2012 US 201261704980 P
01.08.2013 US 201313957388**

(43) Date of publication of application:
**26.03.2014 Bulletin 2014/13**

(73) Proprietor: **Samsung SDI Co., Ltd.
Gyeonggi-do (KR)**

(72) Inventors:
• **Sim, Se-Sub
Gyeonggi-do (KR)**
• **Segawa, Susumu
Gyeonggi-do (KR)**
• **Omagari, Masami
Gyeonggi-do (KR)**
• **Lee, Yong-Dai
Gyeonggi-do (KR)**
• **Kim, Jin-Wan
Gyeonggi-do (KR)**

(74) Representative: **Walaski, Jan Filip
Venner Shipley LLP
200 Aldersgate
London EC1A 4HD (GB)**

(56) References cited:
**EP-A1- 0 593 770    US-A1- 2011 312 391**

**Description**

The present invention relates to a protection apparatus for a secondary battery, and more particularly, to a protection circuit for a secondary battery, which can prevent a swelling phenomenon from occurring in the secondary battery.

Recently, secondary batteries have been used as power sources of portable electronic devices in many fields, and accordingly, demands on secondary batteries rapidly increase. The secondary batteries can be charged and discharged several times and thus are economically and environmentally effective. Accordingly, the use of the secondary batteries is promoted.

A swelling phenomenon in which a secondary battery swells at a high temperature/high voltage due to gas or the like may occur in the secondary battery. The swelling phenomenon may cause an electrical short circuit. If an external impact is applied to the secondary battery in the state in which the secondary battery swells, a spark or the like occurs, and therefore, the secondary battery may explode.

Conventionally, the swelling phenomenon was overcome in such a manner that an extra space was provided in a battery pack having a secondary battery mounted therein so that a user could not perceive the occurrence of a swelling phenomenon of the secondary battery. However, this manner does not meet the tendency of mobile products that gradually get slimmer, and there is a limitation that this manner does not provide a fundamental solution to the swelling phenomenon.

EP0593770 discloses a method and apparatus for charging a nickel-cadmium battery. The temperature and voltage of the battery are monitored. At the time when the temperature-rise rate of the battery is at least twice the increase of the one measured just before, or when the time of such a phenomenon being observed coincides with the time when the sensed voltage-rise rate of the battery lowers firstly after it increases continuously for a predetermined term, the operation of charging the battery is interrupted.

Embodiments provide a protection apparatus for a secondary battery, in which the charging/discharging of the secondary battery is controlled by estimating in advance a risk that a swelling phenomenon may occur in the secondary battery, so that it is possible to take appropriate action before swelling occurs and to prevent the swelling phenomenon from occurring in the secondary battery.

According to an aspect of the present invention, there is provided protection apparatus for a secondary battery as set out in claim 1.

When the measured voltage and estimated temperature satisfy the second swelling condition and the secondary battery is in a non-charging mode, the charging/discharging control means may be arranged to discharge the secondary battery.

During the discharge of the secondary battery the apparatus may be arranged to determine if the measured voltage and estimated temperature satisfy the first swelling condition or if the temperature is decreasing, and in either case to stop discharge.

When the measured voltage and estimated temperature satisfy the second swelling condition and the secondary battery is in a charging mode, the charging/discharging control means may be arranged to adjust the current and/or voltage applied to the secondary battery.

The charging/discharging control means may be arranged to stop charging the secondary battery if the estimated temperature and measured voltage continue to satisfy the second swelling condition after adjusting the current and/or voltage applied to the secondary battery.

The charging/discharging control means may be arranged to discharge the secondary battery if after stopping charging the secondary battery the temperature increases. The means for estimating the battery temperature may be arranged to estimate the battery temperature by using a rate of temperature change based on previously measured temperatures.

The means for estimating the battery temperature may be arranged to weight rates of temperature change so that higher rates of temperature increase have a greater weight.

The temperatures and voltages may comprise temperature and voltage averages measured over predetermined periods.

The swelling condition may comprise a plurality of sets of temperature and allowable voltage values, the allowable voltage values decreasing with increasing temperature.

The measuring means may be arranged to measure temperature and voltage of the secondary battery less frequently when the secondary battery is in a non-charging mode than when the secondary battery is in a charging mode.

A secondary battery may comprise a battery cell and protection apparatus as described above connected to the battery cell.

According to the present invention, it is possible to prevent, in advance, a swelling phenomenon from occurring in a secondary battery by estimating in advance a risk that the swelling phenomenon will occur in the secondary battery and controlling charging/discharging of the secondary battery when the risk exists.

The accompanying drawings illustrate exemplary embodiments of the present invention, and, together with the description, serve to explain the principles of the present invention.

FIG. 1 is a block diagram schematically showing a protection apparatus for a secondary battery according to an embodiment of the present invention;
FIG. 2 is a block diagram showing a detailed configuration of the protection apparatus according to the embodiment of the present invention;
FIG. 3 is a graph illustrating a swelling condition and an operation of a charging/discharging control unit according to the swelling condition;
FIG. 4 is a flowchart illustrating a control method of the protection apparatus according to an embodiment of the present invention; and
FIG. 5 is a flowchart illustrating an operation of the charging/discharging control unit according to an embodiment of the present invention.

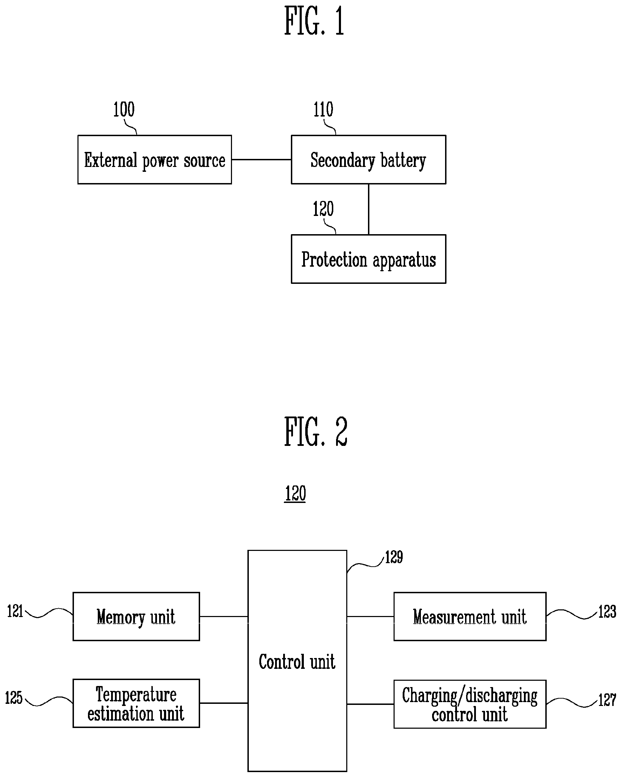

Referring to FIG. 1, the protection apparatus 120 is coupled to a secondary battery 110 so as to control charging/discharging of the secondary battery 110.

Here, an external power source 100 refers to a power source that charges the secondary battery 110 by applying current to the secondary battery 110. For example, the external power source 100 may be an AC adapter coupled to a charging device of the secondary battery 110 so as to apply current to the secondary battery 110, but the present invention is not limited thereto. That is, the external power source 100 may include all power sources that can apply current to the secondary battery 110.

The secondary battery 110 refers to a rechargeable battery. The secondary battery 110 may include a lead-acid battery, a nickel cadmium (NiCd) battery, a nickel metal hydride (NiMH) battery, a lithium ion battery (LiB), a lithium polymer battery (LiPB), and the like.

The swelling phenomenon that occurs in the secondary battery 110 is an irreversible phenomenon. Therefore, to maintain stable performance of the secondary battery 110, it is important to prevent the swelling phenomenon from occurring in the secondary battery 110.

The protection apparatus 120 according to the present invention estimates a risk that the swelling phenomenon will occur in the secondary battery 110 by monitoring the temperature and voltage of the secondary battery 110, and controls the charging/discharging of the secondary battery 110, so that it is possible to prevent, in advance, the swelling phenomenon of the secondary battery 110.

According to an embodiment of the present invention, the protection apparatus 120 may be coupled to the secondary battery 110 so as to form a battery pack, or may be provided to an electronic device or charging device to which the secondary battery 110 is coupled so as to protect the secondary battery 110.

Hereinafter, the driving principle of the protection apparatus 120 will be described in detail with reference to FIG. 2.

Referring to FIG. 2, the protection apparatus 120 may include a memory unit 121, a measurement unit 123, a temperature estimation unit 125, a charging/discharging control unit 127 and a control unit 129.

The memory unit 121 stores first and second swelling conditions of temperatures and voltages.

The first swelling condition refers to conditions in which there is a high risk that the swelling phenomenon will occur, and the second swelling condition refers to conditions in which the swelling phenomenon will almost inevitably occur. For example, the first and second swelling conditions may be stored in the memory unit 121 as shown in the following Tables 1 and 2.

Table 1

| • First swelling condition | | | | | |
|---|---|---|---|---|---|
| Temperature (T) | $40 \leq T < 45$ | $45 \leq T < 50$ | $50 \leq T < 55$ | $55 \leq T < 60$ | $60 \leq T$ |
| Voltage (V) | $4.1 < V \leq 4.2$ | $4.0 < V \leq 4.1$ | $3.9 < V \leq 4.0$ | $3.8 < V \leq 3.9$ | $3.7 < V \leq 3.8$ |

Table 2

| • Second swelling condition | | | | | |
|---|---|---|---|---|---|
| Temperature (T) | $40 \leq T < 45$ | $45 \leq T < 50$ | $50 \leq T < 55$ | $55 \leq T < 60$ | $60 \leq T$ |
| Voltage (V) | $4.2 < V$ | $4.1 < V$ | $4.0 < V$ | $3.9 < V$ | $3.8 < V$ |

Generally, as the temperature of the secondary battery 10 increases, the allowable voltage of the secondary battery 110 decreases. Therefore, as the temperature of the secondary battery 110 increases under the first and second swelling conditions, the allowable voltage of the secondary battery 110 decreases.

According to Tables 1 and 2, in a case where the temperature of the secondary battery 110 is 47 degrees and the voltage of the secondary battery 110 is 4.05V, the first swelling condition is satisfied. In a case where the temperature of the secondary battery 110 is 47 degrees and the voltage of the secondary battery 110 is 4.2V, the second swelling condition is satisfied.

It will be apparent to those skilled in the art that the first and second swelling conditions are merely examples for illustrating the present invention, and may be variously set by a user according to the kind of the secondary battery 110, the charging capacity of the secondary battery 110, the charging environment of the secondary battery 110, and the like. In other words, the swelling conditions are not limited to particular voltage and temperature combinations, but may include other parameters that indicate a risk of swelling occurring. Furthermore, the specific values given in the tables above are illustrative only. The first and second swelling conditions will be described in detail with reference to the accompanying drawings.

The measurement unit 123 measures temperatures and voltages of the secondary battery 110 according to predetermined measurement periods and measurement frequency. For example, in the case where the protection apparatus 120 operates in a non-charging mode, the measurement unit 123 may measure temperatures and voltages of the secondary battery 110 less frequently than in the case where the protection apparatus 120 operates in a charging mode, since the risk of swelling is greater in the charging mode than in the non-charging mode.

According to an embodiment of the present invention, in the case where the measured temperatures and voltages of the secondary battery 110 satisfy the first swelling condition, the measurement unit 123 may measure the temperatures and voltages of the secondary battery 110 by increasing the measurement frequency. Generally, the swelling phenomenon tends to rapidly occur in the secondary battery 110 according to the temperature and charging state of the secondary battery 110. Thus, in a case where the measured temperatures and voltages of the secondary battery 110 satisfy the first swelling condition, the measurement unit 123 measures temperatures and voltages of the secondary battery 110 more frequently, so that it is possible to rapidly prevent the swelling phenomenon from occurring in the secondary battery 110. For example, if each measurement is made during a measurement time, the interval between measurement times is decreased so that more measurements are made in any given time period.

According to an embodiment of the present invention, the measurement unit 123 may compute a temperature average and a voltage average using temperatures and voltages measured during predetermined times and store the temperature and voltage averages in the memory unit 121.

For example, the measurement unit 123 may compute a temperature average of temperatures measured for 1 minute and a voltage average of voltages measured for 2 seconds, and store the temperature and voltage averages in the memory unit 121. In a case where the measurement period is 250msec, the temperature average means an average of temperatures measured 240 times, and the voltage average means an average of voltages measured eight times. That is, the voltage and temperature averages computed in the measurement unit 123 may be renewed every two seconds and every one minute, respectively. Then, the renewed voltage and temperature averages may be stored in the memory unit 121. To perform temperature estimation, a predetermined number of past temperature averages may be stored together with the renewed temperature average in the memory unit 121. Since temperature changes relatively slowly while voltage changes more rapidly, the temperature average may be measured over a longer period for reliability, while the voltage average is measured over a relatively short period to capture rapid changes in voltage.

The temperature and voltage averages are used in the temperature estimation and control of the charging/discharging of the secondary battery 110. Exceptionally measured temperatures and voltages, i.e. outlying data, are removed. Accordingly, more exact temperature estimation can be performed.

Hereinafter, for convenience of illustration, it will be described that the temperature and voltage measured in the measurement unit 123 are a temperature average of temperatures, renewed every predetermined period, and a voltage average of voltages, renewed every predetermined period, respectively. However, the present invention is not limited thereto.

In the case where the temperatures and voltages measured in the measurement unit 123 satisfy the first swelling condition, the temperature estimation unit 125 estimates a temperature after a predetermined time, in other words at a future time, using temperatures measured in the measurement unit 123.

More specifically, the temperature estimation unit 125 may estimate the temperature after the predetermined time by using the temperature increasing rate computed using a temperature average before the predetermined time and a recently renewed temperature average. The temperature increasing rate and the estimated temperature after the predetermined time may be represented by the following Formula 1.

*Formula 1*

Temperature increasing rate = (Currently measured temperature average −

Temperature average before predetermined time)/ measurement time interval

Estimated temperature = Current temperature + (Temperature increasing rate x time

interval)

For example, in the case where the temperature average measured over a 10 minute interval rises from 42 degrees to 47 degrees, then the temperature increasing rate, or rate of change of temperature, is 0.5 degrees per minute. If the current temperature is 48 degrees, then the estimated temperature after a further 10 minutes can be calculated as 48 + (0.5 x 10) =53 degrees.

According to an embodiment of the present invention, the temperature estimation unit 125 may estimate a temperature after a predetermined time using a weight according to the temperature increasing rate. That is, since the swelling phenomenon rapidly occurs in the secondary battery 110, the probability that the swelling phenomenon will occur in the secondary battery 110 increases as the temperature increasing rate increases. Therefore, to reflect this fact, the estimated temperature may be increased by increasing the weight as the temperature increasing rate increases. In this case, the estimated temperature may be represented by the following Formula 2.

*Formula 2*

Estimated temperature = Current temperature + (Temperature increasing rate ×

Weight) x time interval

For example, in a case where the weight is 1.1 when the temperature increasing rate is 1 degree per unit time, the weight is 1.5 when the temperature increasing rate is 4 degrees per unit time, and the current temperature is 40 degrees, the estimated temperatures per unit time become $(1.1 \times 1)+40=41$ degrees and $(4 \times 1.5)+40=46$ degrees, respectively. That is, as the temperature increasing rate increases, the temperature estimated in the temperature estimation unit 125 increases, and accordingly, the probability that the estimated temperature and the voltage average will satisfy the second swelling condition increases.

In the case where the estimated temperature and the voltage average satisfy the second swelling condition, the charging/discharging control unit 127 prevents the swelling phenomenon from occurring in the secondary battery 110 by controlling the charging/discharging of the secondary battery 110.

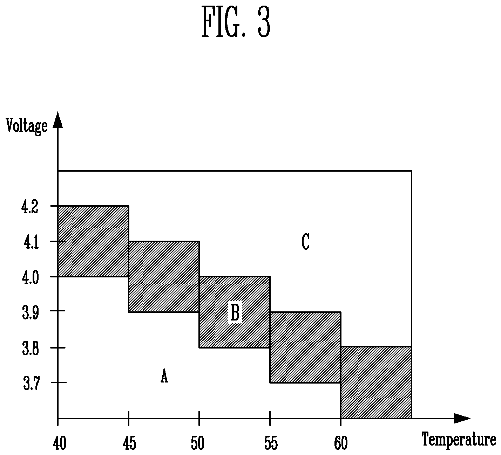

FIG. 3 is a graph illustrating a swelling condition and an operation of the charging/discharging control unit according to the swelling condition.

Referring to FIG. 3, regions A, B and C refer to a normal region where the battery is operating within normal parameters and swelling is not expected, a swelling preliminary region where swelling becomes a risk and a swelling region in which swelling will almost inevitably occur, respectively. That is, the region that satisfies the first swelling condition is shown as the region B, and the region that satisfies the second swelling condition is shown as the region C.

Therefore, in the case where the temperatures and voltages measured in the measurement unit 123 exist in the region B, the protection apparatus 120 decides that there is a risk that the swelling phenomenon may occur in the secondary battery 110, and estimates a temperature after a predetermined time through the temperature estimation unit 125. In the case where the estimated temperature and the voltage average renewed every predetermined time is out of the region B and exists in the region C, the charging/discharging control unit 127 controls the charging/discharging of the secondary battery 110 so as to prevent the swelling phenomenon from occurring in the secondary battery 110, in other words to prevent the conditions within the battery actually falling within region C.

According to an embodiment of the present invention, in the case where the secondary battery 110 is in a non-charging mode, the charging/discharging control unit 127 may control the temperature and voltage of the secondary battery 110 to maintain the first swelling condition or move the battery out of the first swelling condition into the normal operating condition by forcibly discharging the secondary battery 110 and thus decreasing the voltage of the secondary battery 110. In the case where the temperature and voltage of the secondary battery 110 exist in the region A according to the discharging of the secondary battery 110, the charging/discharging control unit 127 may stop the discharging of the secondary battery 110.

According to an embodiment of the present invention, in the case where the secondary battery 110 is in a charging mode, the charging/discharging control unit 127 may control the temperature and voltage of the secondary battery 110 to maintain the first swelling condition or move the battery out of the first swelling condition into the normal operating condition by adjusting the current or voltage applied to the secondary battery 110. In the case where the temperature and voltage of the secondary battery 110 satisfy the second swelling condition even though the current or voltage applied to the secondary battery 110 is adjusted, the charging/discharging control unit 127 may stop the charging of the secondary battery 110 by cutting off the current or voltage applied to the secondary battery 110.

In the case where the temperature increasing rate exceeds zero, after the charging of the secondary battery 110 is stopped, the charging/discharging control unit 127 may forcibly discharge the secondary battery 110. Subsequently, in the case where the temperature and voltage of the secondary battery 110 satisfy the first swelling condition or the temperature increasing rate is less than zero, after the discharging of the secondary battery 110, the charging/discharging control unit 127 may stop the discharging of the secondary battery 110.

According to an embodiment of the present invention, in the case where the temperatures and voltages measured in the measurement unit 123 have already satisfied the second swelling condition, the charging/discharging control unit 127 may immediately stop the charging of the secondary battery 110 and control the secondary battery 110 to be forcibly discharged.

The control unit 129 may generally control the memory unit 121, the measurement unit 123, the temperature estimation unit 125 and the charging/discharging control unit 127.

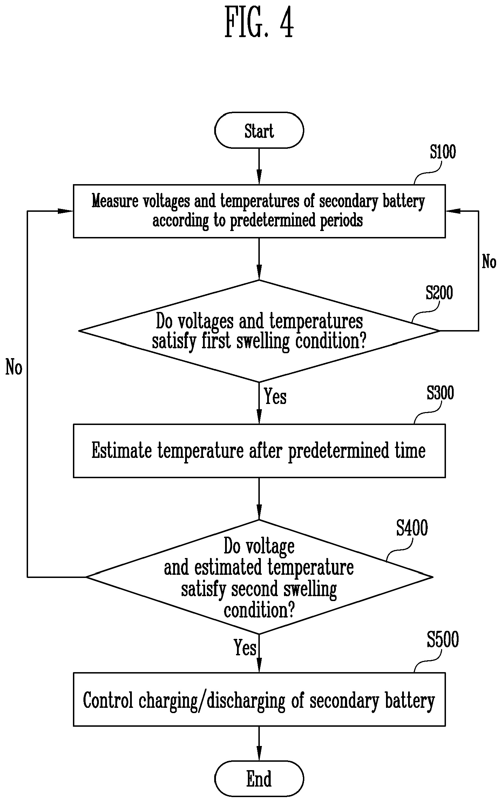

FIG. 4 is a flowchart illustrating a control method of the protection apparatus according to an embodiment of the present invention.

First, the measurement unit 123 measures voltages and temperatures of the secondary battery 110 according to predetermined periods (S100).

The measurement unit 123 decides whether or not the measured voltages and temperatures satisfy a first swelling condition (S200). In the case where the measured voltages and temperatures satisfy the first swelling condition, the temperature estimation unit 125 estimates a temperature after a predetermined time (at a future time) using the temperatures measured in the measurement unit 123 (S300).

In a case where the measured voltages and temperatures satisfy the first swelling condition, the measurement unit 123 may measure temperatures and voltages of the secondary battery 110 by increasing the measurement frequency. To perform exact temperature estimation, the measurement unit 123 may compute temperature and voltage averages that are averages of temperatures and voltage measured for times set differently from each other.

The charging/discharging control unit 127 decides whether or not the estimated temperature and the voltage average satisfy a second swelling condition (S400). In the case where the estimated temperature and the voltage average satisfy the second swelling condition, the charging/discharging control unit 127 controls charging/discharging of the secondary battery 110 (S500).

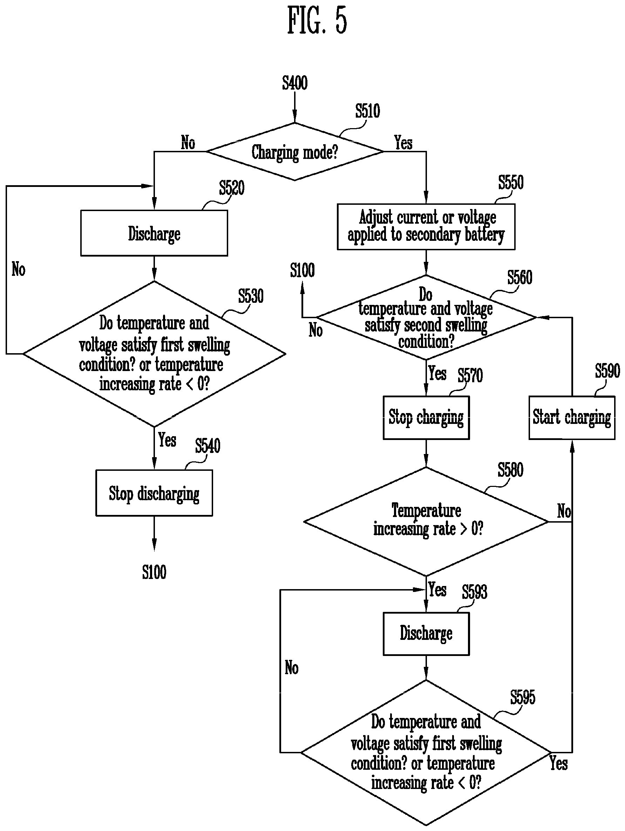

FIG. 5 is a flowchart illustrating an operation of the charging/discharging control unit according to an embodiment of the present invention.

Referring to FIG. 5, the charging/discharging control unit 127 decides whether the secondary battery 110 is in a charging mode or in a non-charging mode (S510).

In the case where the secondary battery 110 is in the non-charging mode, the charging/discharging control unit 127 forcibly discharges the secondary battery 110, so that it is possible to prevent, in advance, the swelling phenomenon from occurring in the secondary battery 110 (S520).

Subsequently, in the case where the temperatures and voltages of the secondary battery 110 satisfy the first swelling condition, or the temperature increasing rate is less than zero (S530), the charging/discharging control unit 127 may stop the forcible discharging of the secondary battery 110 (S540). If not, the forcible discharge continues (step S520).

In the case where the secondary battery 110 is in the charging mode (S510), the charging/discharging control unit 127 control the temperatures and voltages of the secondary battery 110 to maintain the first swelling condition by adjusting current and voltage applied to the secondary battery 110 (S550).

The charging/discharging control unit 127 decides whether or not the temperatures and voltages of the secondary battery 110 satisfy the second swelling condition (S560). In the case where the temperatures and voltages of the secondary battery 110 satisfy the second swelling condition even though the current or voltage applied to the secondary battery 110 is adjusted, the charging/discharging control unit 127 stops the charging of the secondary battery 110 (S570). Otherwise, the charging/discharging control unit 127 returns to the monitoring state, carrying out voltage and temperature measurements (S100).

In the case where the temperature increasing rate of the secondary battery 110 exceeds zero even though the charging of the secondary battery 110 is stopped (S580), the charging/discharging control unit 127 forcibly discharges the secondary battery 110 (S593), so that it is possible to prevent the swelling phenomenon from occurring in the secondary battery 110. Forcible discharge continues until the temperature and voltage satisfy the first swelling condition or the rate of temperature increase falls below zero, ie. temperature starts to decrease (S595). At that point, forcible discharge is stopped and the battery can return to the charging condition (S590).

As described above, the protection apparatus 120 according to the present invention estimates in advance a risk that the swelling phenomenon may occur in the secondary battery 110, and controls the charging/discharging of the secondary battery 110 when the risk exists, so that it is possible to prevent, in advance, the swelling phenomenon from occurring in the secondary battery 110. A preliminary swelling condition (first swelling condition) may be implemented in which measurement frequency is increased as compared to when the battery is operating normally and no swelling is expected, so as to more closely monitor the state of the battery as the risk of swelling increases.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. Protection apparatus (120) for a secondary battery (120), comprising:

   means (121) configured to store temperature and voltage information defining a swelling condition of a secondary battery (120);
   means (123) configured to measure temperature and voltage of the secondary battery (120);
   means (125) configured to estimate the battery temperature at a predetermined time based on the measured temperature; and
   means (127) configured to control charging/discharging of the secondary battery (120) when the estimated temperature and the measured voltage satisfy the swelling condition;
   the protection apparatus being **characterised in that** the stored temperature and voltage define first and second swelling conditions, **in that** the estimating means (125) is arranged to start estimating the battery temperature when the first swelling condition is satisfied and the means (127) for controlling charging/discharging is arranged to operate when the estimated temperature and the measured voltage satisfy the second swelling condition;
   and **in that** the measuring means (123) is arranged to measure temperature and voltage of the secondary battery (120) in a normal state at a first frequency and to measure temperature and voltage of the secondary battery (120) at a second frequency higher than the first frequency when the measured temperature and voltage satisfy the first swelling condition.

2. Apparatus according to claim 1, wherein when the measured voltage and estimated temperature satisfy the second swelling condition and the secondary battery is in a non-charging mode, the charging/discharging control means is arranged to discharge the secondary battery.

3. Apparatus according to claim 2, wherein during the discharge of the secondary battery (120) the apparatus is arranged to determine if the measured voltage and estimated temperature satisfy the first swelling condition or if the temperature is decreasing, and in either case to stop discharge.

4. Apparatus according to claim 1, wherein when the measured voltage and estimated temperature satisfy the second swelling condition and the secondary battery (120) is in a charging mode, the charging/discharging control means (127) is arranged to adjust the current and/or voltage applied to the secondary battery (120).

5. Apparatus according to claim 4, wherein the charging/discharging control means (127) is arranged to stop charging the secondary battery (120) if the estimated temperature and measured voltage continue to satisfy the second swelling condition after adjusting the current and/or voltage applied to the secondary battery (120).

6. Apparatus according to claim 5, wherein the charging/discharging control means (127) is arranged to discharge the secondary battery (120) if after stopping charging the secondary battery (120) the temperature increases.

7. Apparatus according to any one of the preceding claims, wherein the means (125) configured to estimate the battery temperature is arranged to estimate the battery temperature by using a rate of temperature change based on previously measured temperatures.

8. Apparatus according to claim 7, wherein the means (125) configured to estimate the battery temperature is arranged to weight rates of temperature change so that higher rates of temperature increase have a greater weight.

9. Apparatus according to any one of the preceding claims, wherein the temperatures and voltages comprise temperature and voltage averages measured over predetermined periods.

10. Apparatus according to any one of the preceding claims, wherein the swelling condition comprises a plurality of sets of temperature and allowable voltage values, the allowable voltage values decreasing with increasing temperature.

11. Apparatus according to any one of the preceding claims, wherein the measuring means (123) is arranged to measure temperature and voltage of the secondary battery (120) less frequently when the secondary battery (120) is in a non-charging mode than when the secondary battery (120) is in a charging mode.

12. A secondary battery comprising a battery cell and apparatus according to any one of the preceding claims connected to the battery cell.

**Patentansprüche**

1. Schutzvorrichtung (120) für eine Sekundärbatterie (120), umfassend:

   ein Mittel (121), das dazu ausgelegt ist, Temperatur- und Spannungsinformationen, die eine Quellbedingung einer Sekundärbatterie (120) definieren, zu speichern;

      ein Mittel (123), das dazu ausgelegt ist, Temperatur und Spannung der Sekundärbatterie (120) zu messen; ein Mittel (125), das dazu ausgelegt ist, die Batterietemperatur zu einem vorbestimmten Zeitpunkt auf der Grundlage der gemessenen Temperatur zu schätzen; und ein Mittel (127), das dazu ausgelegt ist, das Laden/Entladen der Sekundärbatterie (120) zu steuern, wenn die geschätzte Temperatur und die gemessene Spannung die Quellbedingung erfüllen; wobei die Schutzvorrichtung **dadurch gekennzeichnet ist, dass** die gespeicherte Temperatur und Spannung eine erste und eine zweite Quellbedingung definieren, dass das Schätzmittel (125) dazu angeordnet ist, das Schätzen der Batterietemperatur zu beginnen, wenn die erste Quellbedingung erfüllt ist, und das Mittel (127) zum Steuern des Ladens/Entladens dazu angeordnet ist, betrieben zu werden, wenn die geschätzte Temperatur und die gemessene Spannung die zweite Quellbedingung erfüllen; und dadurch, dass das Messmittel (123) dazu angeordnet ist, die Temperatur und die Spannung der Sekundärbatterie (120) in einem Normalzustand bei einer ersten Frequenz zu messen und die Temperatur und die Spannung der Sekundärbatterie (120) bei einer zweiten Frequenz, die höher als die erste Frequenz ist, zu messen, wenn die gemessene Temperatur und Spannung die erste Quellbedingung erfüllen.

2. Vorrichtung nach Anspruch 1, wobei das Mittel zum Steuern des Ladens/Entladens dazu angeordnet ist, die Sekundärbatterie zu entladen, wenn die gemessene Spannung und die geschätzte Temperatur die zweite Quellbedingung erfüllen und sich die Sekundärbatterie in einem Nichtlademodus befindet.

3. Vorrichtung nach Anspruch 2, wobei die Vorrichtung dazu angeordnet ist, während der Entladung der Sekundärbatterie (120) zu bestimmen, ob die gemessene Spannung und die geschätzte Temperatur die erste Quellbedingung erfüllen oder ob die Temperatur abnimmt, und in beiden Fällen die Entladung zu stoppen.

4. Vorrichtung nach Anspruch 1, wobei das Mittel (127) zum Steuern des Ladens/Entladens dazu angeordnet ist, den Strom und/oder die Spannung, der bzw. die an der Sekundärbatterie (120) anliegen, anzupassen, wenn die gemessene Spannung und die geschätzte Temperatur die zweite Quellbedingung erfüllen und sich die Sekundärbatterie (120) in einem Lademodus befindet.

5. Vorrichtung nach Anspruch 4, wobei das Mittel (127) zum Steuern des Ladens/Entladens dazu angeordnet ist, das Laden der Sekundärbatterie (120) zu stoppen, wenn die geschätzte Temperatur und die gemessene Spannung nach dem Anpassen des Stroms und/oder der Spannung, der bzw. die an der Sekundärbatterie (120) anliegen, weiterhin die zweite Quellbedingung erfüllt.

6. Vorrichtung nach Anspruch 5, wobei das Mittel (127) zum Steuern des Ladens/Entladens dazu angeordnet ist, die Sekundärbatterie (120) zu entladen, wenn nach dem Stoppen des Ladens der Sekundärbatterie (120) die Temperatur ansteigt.

7. Vorrichtung nach einem der vorangehenden Ansprüche, wobei das zum Schätzen der Batterietemperatur ausgelegte Mittel (125) dazu angeordnet ist, die Batterietemperatur anhand einer Temperaturänderungsrate auf der Grundlage von zuvor gemessenen Temperaturen zu schätzen.

8. Vorrichtung nach Anspruch 7, wobei das zum Schätzen der Batterietemperatur ausgelegte Mittel (125) dazu angeordnet ist, Temperaturänderungsraten so zu gewichten, dass höhere Temperaturanstiegsraten ein größeres Gewicht haben.

9. Vorrichtung nach einem der vorangehenden Ansprüche, wobei die Temperaturen und Spannungen über vorbestimmte Zeiträume gemessene Temperatur- und Spannungsdurchschnitte umfassen.

10. Vorrichtung nach einem der vorangehenden Ansprüche, wobei die Quellbedingung eine Mehrzahl von Sätzen von Temperatur- und zulässigen Spannungswerten umfasst, wobei die zulässigen Spannungswerte mit ansteigender Temperatur abnehmen.

11. Vorrichtung nach einem der vorangehenden Ansprüche, wobei das Messmittel (123) dazu angeordnet ist, Temperatur und Spannung der Sekundärbatterie (120) weniger häufig zu messen, wenn sich die Sekundärbatterie (120) in einem Nichtlademodus befindet, als wenn sich die Sekundärbatterie (120) in einem Lademodus befindet.

12. Sekundärbatterie, umfassend eine Batteriezelle, und Vorrichtung nach einem der vorangehenden Ansprüche, die mit der Batteriezelle verbunden ist.


**Revendications**

1. Appareil de protection (120) pour une batterie secondaire (120), comprenant :

   un moyen (121) configuré pour stocker des informations de température et de tension définissant une condition de gonflement d'une batterie secondaire (120) ;
   un moyen (123) configuré pour mesurer la température et la tension de la batterie secondaire (120) ;
   un moyen (125) configuré pour estimer la température de batterie à un moment prédéterminé sur la base de la température mesurée ; et
   un moyen (127) configuré pour commander la charge/décharge de la batterie secondaire (120) lorsque la température estimée et la tension mesurée satisfont la condition de gonflement ;
   l'appareil de protection étant **caractérisé en ce que** la température et la tension stockées définissent des première et deuxième conditions de gonflement,
   **en ce que** le moyen d'estimation (125) est conçu pour commencer l'estimation de la température de batterie lorsque la première condition de gonflement est satisfaite et le moyen (127) pour commander la charge/décharge est conçu pour fonctionner lorsque la température estimée et la tension mesurée satisfont la deuxième condition de gonflement ;

   et **en ce que** :

   le moyen de mesure (123) est conçu pour mesurer la température et la tension de la batterie secondaire (120) dans un état normal à une première fréquence et pour mesurer la température et la tension de la batterie secondaire (120) à une deuxième fréquence supérieure à la première fréquence lorsque la température et la tension mesurées satisfont la première condition de gonflement.

2. Appareil selon la revendication 1, dans lequel, lorsque la tension mesurée et la température estimée satisfont la deuxième condition de gonflement et que la batterie secondaire est dans un mode hors charge, le moyen de commande de charge/décharge est conçu pour décharger la batterie secondaire.

3. Appareil selon la revendication 2, où, pendant la décharge de la batterie secondaire (120), l'appareil est conçu pour déterminer si la tension mesurée et la température estimée satisfont la première condition de gonflement ou si la température diminue, et dans les deux cas pour arrêter la décharge.

4. Appareil selon la revendication 1, dans lequel, lorsque la tension mesurée et la température estimée satisfont la deuxième condition de gonflement et que la batterie secondaire (120) est dans un mode de charge, le moyen de commande de charge/décharge (127) est conçu pour ajuster le courant et/ou la tension appliqué(e) à la batterie secondaire (120).

5. Appareil selon la revendication 4, dans lequel le moyen de commande de charge/décharge (127) est conçu pour arrêter la charge de la batterie secondaire (120) si la température estimée et la tension mesurée continuent à satisfaire la deuxième condition de gonflement après ajustement du courant et/ou de la tension appliqué (e) à la batterie secondaire (120).

6. Appareil selon la revendication 5, dans lequel le moyen de commande de charge/décharge (127) est conçu pour décharger la batterie secondaire (120) si, après l'arrêt de la charge de la batterie secondaire (120), la température augmente.

7. Appareil selon l'une quelconque des revendications précédentes, dans lequel le moyen (125) configuré pour estimer la température de batterie est conçu pour estimer la température de batterie en utilisant un taux de variation de température sur la base des températures précédemment mesurées.

8. Appareil selon la revendication 7, dans lequel le moyen (125) configuré pour estimer la température de batterie est conçu pour pondérer des taux de variation de température de sorte que des taux plus élevés d'augmentation de température aient un poids plus important.

9. Appareil selon l'une quelconque des revendications précédentes, dans lequel les températures et les tensions comprennent des moyennes de température et de tension mesurées sur des périodes prédéterminées.

10. Appareil selon l'une quelconque des revendications précédentes, dans lequel la condition de gonflement comprend une pluralité d'ensembles de températures et de valeurs de tension admissible, les valeurs de tension admissible diminuant avec l'augmentation de température.

11. Dispositif selon l'une quelconque des revendications précédentes, dans lequel le moyen de mesure (123) est conçu pour mesurer la température et la tension de la batterie secondaire (120) moins fréquemment lorsque la batterie secondaire (120) est dans un mode hors charge que lorsque la batterie secondaire (120) est dans un mode de charge.

12. Batterie secondaire comprenant un élément de batterie et un appareil selon l'une quelconque des revendications précédentes relié à l'élément de batterie.

# FIG. 1

External power source — 100

Secondary battery — 110

Protection apparatus — 120

# FIG. 2

120

Memory unit — 121

Temperature estimation unit — 125

Control unit — 129

Measurement unit — 123

Charging/discharging control unit — 127

FIG. 3

# FIG. 4

```
                              Start
                                │
                                ▼                            S100
        ┌────────────────────────────────────────────────┐
  ┌────▶│ Measure voltages and temperatures of secondary  │◀────┐
  │     │ battery according to predetermined periods       │     │
  │     └────────────────────────────────────────────────┘     │
  │                             │                                │
  │                             ▼                      S200      │ No
  │                      ╱───────────────╲                       │
  │                  ╱   Do voltages and    ╲                    │
  │                 ⟨   temperatures satisfy  ⟩──────────────────┘
  │                  ╲  first swelling cond.? ╱
  │                      ╲───────────────╱
  │                             │ Yes
  │                             ▼                      S300
  │     ┌────────────────────────────────────────────────┐
  │     │  Estimate temperature after predetermined time  │
  │     └────────────────────────────────────────────────┘
  │                             │
  │                             ▼                      S400
  │                      ╱───────────────╲
  │ No               ╱    Do voltage and   ╲
  └─────────────────⟨   estimated temperature ⟩
                     ╲  satisfy second swelling ╱
                      ╲      condition?    ╱
                          ╲───────────╱
                                │ Yes                 S500
        ┌────────────────────────────────────────────────┐
        │  Control charging/discharging of secondary      │
        │  battery                                         │
        └────────────────────────────────────────────────┘
                                │
                                ▼
                               End
```

# FIG. 5

**EP 2 712 018 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0593770 A